# FASCICULE DE BREVET EUROPEEN

(11) **EP 3 391 545 B1**
(45) Date de publication et mention de la délivrance du brevet: **22.05.2024**
(21) Numéro de dépôt: 16809848.1
(22) Date de dépôt: 15.12.2016
(51) Int. Cl.: H03M 7/30

(54) **COMPRESSION DE DONNEES NUMERIQUES**
DIGITALE DATENKOMPRIMIERUNG
DIGITAL DATA COMPRESSION

(30) Priorité: 16.12.2015 FR 1562553
(43) Date de publication de la demande: 24.10.2018
(73) Titulaire: Commissariat à l'Energie Atomique et aux Energies Alternatives, 75015 Paris (FR)
(72) Inventeur: THEVENIN, Mathieu, 91400 Saclay (FR); THOMINE, Olivier, 92120 Montrouge (FR); LATU, Guillaume, 04100 Manosque (FR)
(74) Mandataire: Brevalex
(86) Numéro de dépôt international: PCT/EP2016/081284
(87) Numéro de publication internationale: WO 2017/103002

(56) Documents cités:
- WO-A1-85/02732
- WO-A1-2012/059124
- US-B1- 6 396 420
- MOHAMMAD ARIF ET AL: "Effect on Speech Compression by Combined Delta Encoding and Huffman Coding Scheme", WIRELESS PERSONAL COMMUNICATIONS., vol. 79, no. 3, 28 août 2014 (2014-08-28), pages 2371-2381, XP055292432, NL ISSN: 0929-6212, DOI: 10.1007/s11277-014-1989-3
- Anonymous: "Huffman coding", Wikipedia, 1 December 2015 (2015-12-01), pages 1-10, XP055851071, Retrieved from the Internet: URL:https://en.wikipedia.org/w/index.php?t itle=Huffman_coding&oldid=693246219 [retrieved on 2021-10-13]
- Ratanaworabhan P. ET AL: "Fast Lossless Compression of Scientific Floating-Point Data", Data Compression Conference (DCC'06), 30 March 2006 (2006-03-30), pages 133-142, XP093058302, DOI: 10.1109/DCC.2006.35 ISBN: 978-0-7695-2545-7 Retrieved from the Internet: URL:https://userweb.cs.txstate.edu/~mb92/p apers/dcc06.pdf>
- Elam David - ET AL: "A Block Floating Point Implementation for an N-Point FFT on the TMS320C55x DSP Contents 1 Fixed-and Floating-Point Representations 2 Implementing the Block Floating-Point Algorithm", Application Report, 30 September 2003 (2003-09-30), pages 1-13, XP093057965, Retrieved from the Internet: URL:https://www.ti.com/lit/an/spra948/spra 948.pdf [retrieved on 2023-06-26]

## Description

### DOMAINE TECHNIQUE

La présente invention concerne la compression de données numériques. Elle s'applique à un grand nombre de domaines, par exemple la transmission ou le stockage de signaux tels des images ou des sons.

### ÉTAT DE LA TECHNIQUE ANTÉRIEURE

Les techniques de compression de données comportent fréquemment une détection de répétition de motifs. Les motifs répétés sont ensuite codés à partir de symboles nécessitant moins de données que les données originales.

En outre, il est possible de conditionner les données avant leur compression, de manière à faire apparaître des redondances capables d'améliorer ce type de codage.

Il est encore possible de déterminer les variations dans les données consécutives, et de ne coder que ces variations, comme dans US 6 327 671 ou US 6 038 536.

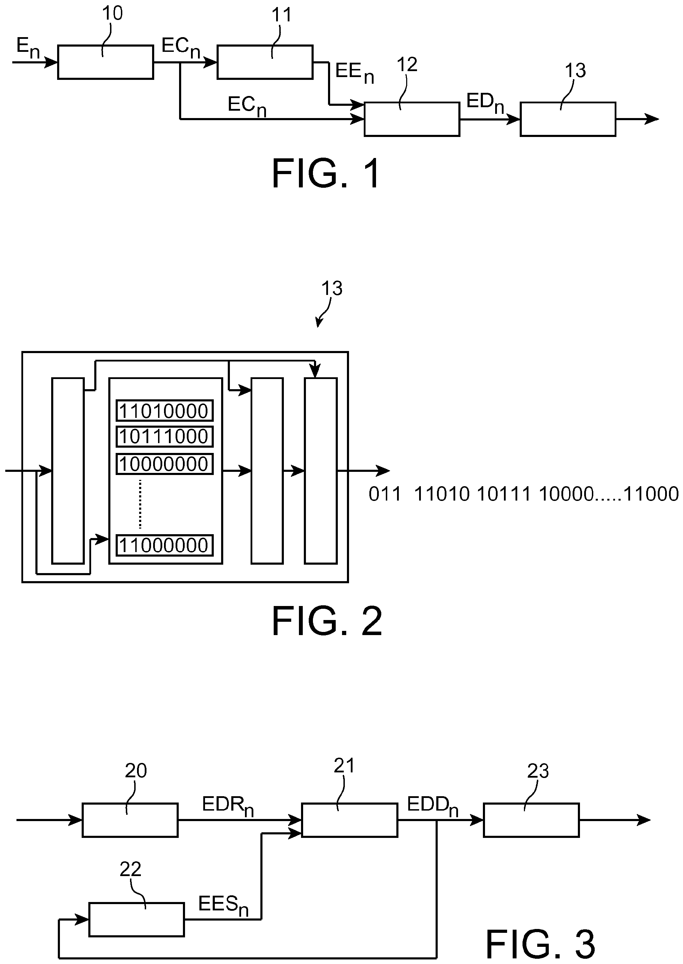

L'article intitulé « The FPC Double-Precision floating-point compression Algorithm and its implementation », de M. Burtscher & P. Ratanaworabhan, concerne une technique de compression de données avec pertes. On voit à la figure 1 qu'une erreur issue d'une décompression avec perte est déterminée. L'erreur ainsi déterminée est compressée. Cette technique implique donc des opérations de compression et de décompression de données dans la seule phase de compression.

L'article "Effect on Speech Compression by Combined Delta Encoding and Huffman Coding Scheme" de Mohammad Arif et Al., Wireless Personal Communications, vol. 79, n° 3, 28 août 2014, pages 2371-2381, divulgue une compression de signal de parole qui comporte tout d'abord un delta codage qui consiste à laisser inchangé un premier échantillon de signal puis à calculer les différences successives entre échantillons successifs du signal. Ce signal delta-codé subit ensuite un codage de Huffman. Cette compression de données est une compression avec pertes dans le cas de nombres à virgule flottante.

L'article intitulé "Fast Lossless Compression of Scientific Floating-Point Data", de Ratanaworabhan P. et Al., décrit un algorithme de compression sans perte pour les valeurs à virgule flottante de 64 bits. Il utilise un prédicteur pour prévoir le prochain élément du tableau en fonction des éléments précédents. Pour compresser un double, il code la différence (résultat XOR) entre la valeur prédite et la valeur réelle. La différence comporte de nombreux bits de zéro de tête si la prédiction est proche de l'élément. Les zéros de tête de chaque élément sont alors codés à l'aide d'un compteur de zéros de tête pour chaque élément.

### EXPOSÉ DE L'INVENTION

L'invention vise à résoudre les problèmes de la technique antérieure et est définie par les revendications ci-jointes.

Grâce à l'invention, les données sont compressées sans perte. La compression utilisée est un algorithme d'ordre N, donc de complexité linéaire, ce qui correspond à la vitesse la plus rapide théoriquement atteignable.

Le temps de calcul nécessaire demeure faible.

Le coût d'implémentation reste limité. En particulier, l'invention peut être mise en oeuvre à moindre coût sur puce en silicium.

L'invention est avantageuse dans de nombreuses applications, car elle permet une augmentation du débit de données transmises sur un canal de bande passante limitée ou encore une augmentation du volume de données stockées dans une mémoire de taille donnée.

### BRÈVE DESCRIPTION DES DESSINS

D'autres caractéristiques et avantages apparaîtront à la lecture de la description suivante d'un mode de réalisation préféré, donné à titre d'exemple non limitatif, décrit en référence aux figures dans lesquelles :
La figure 1 représente un dispositif de compression de données numériques selon un mode de réalisation de l'invention,
La figure 2 représente un mode de réalisation de module de suppression de redondance mis en oeuvre dans le dispositif de la figure 1,
La figure 3 représente un dispositif de décompression de données numériques selon un mode de réalisation de l'invention,
La figure 4 représente un dispositif de compression de données numériques selon un autre mode de réalisation de l'invention,
La figure 5 représente un dispositif de décompression de données numériques selon un autre mode de réalisation de l'invention,
La figure 6 représente un procédé de compression de données numériques selon un mode de réalisation de l'invention,
La figure 7 représente un procédé de décompression de données numériques selon un mode de réalisation de l'invention,
La figure 8 représente un mode de réalisation particulier de mise en oeuvre de dispositif de compression de données selon l'invention.

### EXPOSÉ DÉTAILLÉ DE MODES DE RÉALISATION PARTICULIERS

Selon un mode de réalisation préféré, représenté à la **figure 1****,** le dispositif de compression de données numériques comporte un module de conditionnement 10 qui reçoit les données à compresser.

Dans toute la suite, on considère à titre d'exemple des échantillons de données qui sont des octets. Bien entendu, il est possible de considérer des mots de taille différente, strictement supérieure à 1 bit, par exemple 32 ou 64 bits.

Le conditionnement est une opération optionnelle de mise en forme des données dans le but de faciliter le travail des modules suivants et donc d'améliorer les performances du dispositif. Le conditionnement des données est par exemple le codage des données selon un code de gray, ce qui permet de ne modifier qu'un seul bit à la fois quand un nombre est augmenté d'une unité. Il est aussi possible de changer l'endianness du signal (big endian, little endian), ou encore de modifier l'emplacement du bit de signe, afin d'adapter l'ordre des bits aux traitements ultérieurs.

Une sortie du module de conditionnement 10 est reliée à une entrée d'un module d'extrapolation 11. Le module de conditionnement 10 reçoit des échantillons de données à compresser Eₙ, et délivre des échantillons de données à compresser conditionnées ECₙ au module d'extrapolation 11. L'entier n représente un indice courant d'échantillon, variant entre 1 et une valeur N.

Si le dispositif ne comporte pas de module de conditionnement, le module d'extrapolation 11 reçoit les échantillons de données à compresser Eₙ et leur applique ses traitements.

Le module d'extrapolation 11 applique aux échantillons qu'il reçoit une fonction d'extrapolation qui produit une estimation de la valeur de l'échantillon courant. Différentes fonctions d'extrapolation peuvent être mises en oeuvre. De préférence, la fonction d'extrapolation dépend de la nature du signal à compresser.

A titre d'exemple, la fonction d'extrapolation estime la valeur de l'échantillon courant ECₙ en fonction de la valeur d'au moins un échantillon précédent ECₙ₋₁, ECₙ₋₂, etc. Dans ce cas, la fonction d'extrapolation est par exemple une recopie de l'échantillon précédent. Elle peut également être une fonction, linéaire ou non, de plusieurs échantillons précédents. Alternativement, elle peut encore être une fonction parabolique ou exponentielle.

Si la fonction d'extrapolation estime la valeur de l'échantillon courant ECₙ en fonction de la valeur d'au moins un échantillon précédent ECₙ₋₁, ECₙ₋₂, etc., on a : EEₙ = f(ECₙ₋₁, ECₙ₋₂, ...), où EEₙ représente un échantillon extrapolé courant. Si la fonction d'extrapolation est une recopie de l'échantillon précédent, on a : EEₙ = ECₙ₋₁.

Une sortie du module d'extrapolation 11 est reliée à une entrée d'un module de différenciation 12. Le module d'extrapolation 11 délivre des échantillons estimés, ou extrapolés, EEₙ au module de différenciation 12.

De même, la sortie du module de conditionnement 10 est reliée à une entrée du module de différenciation 12. Le module de conditionnement 10 délivre des échantillons de données à compresser conditionnées ECₙ au module de différenciation 12.

Si le dispositif ne comporte pas de module de conditionnement, le module de différenciation 12 reçoit les échantillons de données à compresser Eₙ.

La différenciation met en oeuvre une fonction déterministe qui associe une unique valeur d'échantillon différencié EDₙ à un couple de valeurs d'échantillon conditionné et d'échantillon extrapolé correspondant (ECₙ, EEₙ).

Les valeurs d'échantillon conditionné ECₙ et d'échantillon extrapolé correspondant EEₙ sont a priori proches, si l'extrapolation fonctionne bien. La fonction de différenciation exploite la redondance existant entre les valeurs d'échantillon conditionné ECₙ et d'échantillon extrapolé correspondant EEₙ. Par exemple, la fonction d'extrapolation est la fonction XOR appliquée bit à bit sur les valeurs d'échantillon conditionné ECₙ et d'échantillon extrapolé correspondant EEₙ. En variante, la fonction d'extrapolation est une soustraction non signée.

Une sortie du module de différenciation 12 est reliée à une entrée d'un module de suppression de redondance 13. Le module de différenciation 12 délivre des échantillons différenciés EDₙ au module de suppression de redondance 13.

La **figure** 2 représente un mode de réalisation de module de suppression de redondance 13 qui travaille sur des blocs de P valeurs successives d'échantillons différenciés et détermine la redondance entre ces P valeurs. Par exemple, le résultat est le nombre NB de bits successifs de poids fort qui ont comme valeur « 0 » dans chacun des P échantillons différenciés considérés. Selon d'autres mises en oeuvre, il est aussi possible de considérer les bits successifs de poids fort qui ont comme valeur « 1 » dans chacun des P échantillons différenciés considérés, ou, dans un mode ne faisant pas partie de l'invention, les bits successifs redondants de poids faible. La valeur P est prédéterminée, ou en variante, elle est variable et est codée dans les données de compression.

Les P valeurs successives d'échantillons différenciés sont mémorisées puis tronquées des NB bits successifs redondants.

Enfin, les P valeurs tronquées, c'est-à-dire les parties non-redondantes des P valeurs successives d'échantillons différenciés, sont concaténées. Le signal de sortie du module 13 est le signal de données compressées produit par le dispositif de compression selon l'invention. Le signal de sortie du module 13 comporte des mots dont chacun correspond à P valeurs traitées et est formé du nombre NB et des P valeurs tronquées.

La **figure 3** représente un mode de réalisation de dispositif de décompression de données compressées par le dispositif de la figure 1.

Le dispositif de décompression comporte un module de dé-concaténation 20 qui reçoit le signal compressé et effectue des opérations inverses de celles du module de suppression de redondance 13 précédemment décrit.

Dans le cas d'une suppression de redondance réalisée comme dans la figure 2, le module de dé-concaténation 20 lit le nombre NB et les P valeurs tronquées d'un mot reçu. Il ajoute les NB bits qui avaient été tronqués à chacune des P valeurs du mot reçu. Par exemple, il ajoute NB bits de poids fort qui ont comme valeur « 0 ». Le module 20 effectue une réintroduction de la redondance dans les données qu'il reçoit et reconstitue ainsi les valeurs des échantillons différenciés. Un échantillon différencié reconstitué EDRₙ est identique à l'échantillon correspondant produit par le module de différenciation 12 du dispositif de compression de données. Un échantillon différencié reconstitué EDRₙ représente l'erreur de la fonction d'extrapolation appliquée par le module 12 lors de la compression des données.

Une sortie du module de dé-concaténation 20 est reliée à une entrée d'un module de dédifférenciation 21. Le module de dé-concaténation 20 délivre les échantillons différenciés reconstitués EDRₙ au module de dédifférenciation 21.

Une sortie d'un module d'estimation 22 est reliée à une autre entrée du module de dédifférenciation 21. Une sortie du module de dédifférenciation 21 est reliée à une entrée du module d'estimation 22.

Le module d'estimation 22 utilise une fonction identique à celle utilisée par le module d'extrapolation 11 du dispositif de compression de données. A partir des échantillons précédemment dédifférenciés EDDₙ fournis par le module de dédifférenciation 21, le module d'estimation 22 produit des échantillons estimés EESₙ. Par exemple, si la fonction d'estimation est une recopie de l'échantillon précédent, on a alors : EESₙ = EDDₙ₋₁, où EDDₙ₋₁ représente l'échantillon précédemment dédifférencié.

Ces échantillons estimés EESₙ sont fournis au module de dédifférenciation 21 qui applique une fonction inverse de la fonction appliquée par le module de différenciation 12 du dispositif de compression de données. Le module de dédifférenciation 21 produit un échantillon dédifférencié EDDₙ en fonction de l'échantillon estimé EESₙ et de l'échantillon différencié reconstitué correspondant EDRₙ fourni par le module 20.

Selon un mode de réalisation préféré, la fonction de différenciation est la fonction « XOR ». Dans ce cas, la fonction appliquée par le module de dédifférenciation 21 est également la fonction « XOR ».

La sortie du module de dédifférenciation 21 est également reliée à une entrée d'un module de déconditionnement 23. Ce module est optionnel et est mis en oeuvre lorsque le dispositif de compression de données comporte un module de conditionnement 10.

Le module de déconditionnement 23 effectue des opérations inverses de celles effectuées par le module de conditionnement 10. Par exemple, si le conditionnement comporte le passage d'un codage de type « big endian » à un codage «de type « little endian », alors le déconditionnement réalise la transformation inverse.

Le signal de sortie du module 23 est le signal de données décompressées produit par le dispositif de décompression selon l'invention. Bien entendu, si les opérations de conditionnement/déconditionnement ne sont pas mises en oeuvre, alors c'est le signal de sortie du module 21 qui est le signal de données décompressées produit par le dispositif de décompression selon l'invention.

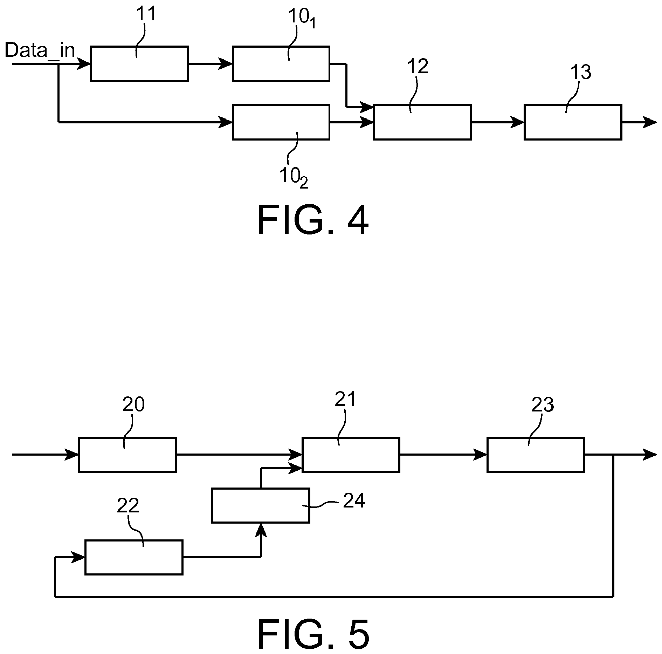

La **figure** 4 représente un autre mode de réalisation de dispositif de compression de données selon l'invention.

Par rapport au mode de réalisation de la figure 1, le module optionnel de conditionnement est déplacé. Plus précisément, le dispositif de compression de données comporte un module d'extrapolation 11, un module de différenciation 12 et un module de suppression de redondance 13 qui sont analogues à ceux précédemment décrits et qui sont désignés respectivement par les mêmes références numériques.

Le dispositif de compression de données comporte un premier module de conditionnement 10₁ entre la sortie du module d'extrapolation 11 et la première entrée du module de différenciation 12 et un second module de conditionnement 10₂ reliée à la seconde entrée du module de différenciation 12.

Le conditionnement des données a donc lieu juste avant la différenciation entre les données à compresser et les données extrapolées.

La **figure 5** représente un autre mode de réalisation de dispositif de décompression de données selon l'invention, correspondant au dispositif de compression de la figure 4.

Par rapport au mode de réalisation de la figure 3, le module optionnel de déconditionnement est déplacé. Plus précisément, le dispositif de décompression de données comporte un module de dé-concaténation 20, un module de dédifférenciation 21 et un module d'estimation 22 qui sont analogues à ceux précédemment décrits et qui sont désignés respectivement par les mêmes références numériques.

Les modules de dé-concaténation 20 et de dédifférenciation 21 travaillent sur des données qui sont conditionnées. Le dispositif de décompression de données comporte un module de déconditionnement 23 entre la sortie du module dédifférenciation 21 et la sortie du dispositif. Le module d'estimation 22 a une entrée reliée à la sortie du module de déconditionnement 23. Ainsi, le module d'estimation 22 travaille sur des données qui ne sont pas conditionnées, comme le module d'extrapolation 11 du dispositif de compression de données.

Un module de conditionnement 24 est relié entre une sortie du module d'estimation 22 et une entrée du module de dédifférenciation 21. Ainsi, les deux entrées du module de dédifférenciation 21 reçoivent des données qui sont conditionnées. Le conditionnement effectué par le module 24 est identique à celui effectué par les modules 10₁ et 10₂ du dispositif de compression de données décrit en référence à la figure 4.

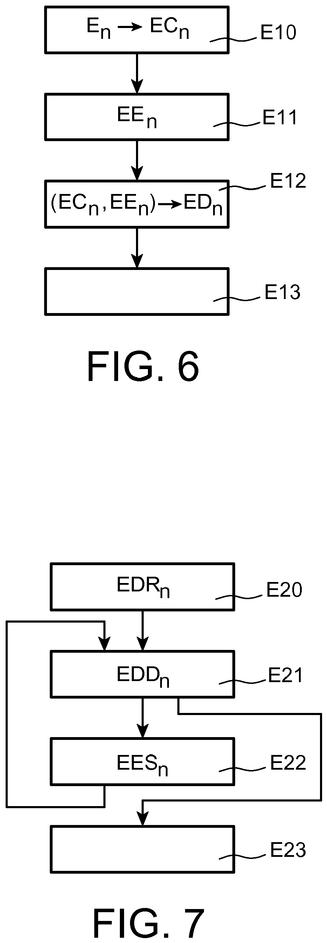

La **figure 6** représente le fonctionnement du dispositif de compression de données de la figure 1, sous la forme d'un organigramme comportant des étapes E10 à E13.

L'étape E10 est un conditionnement des échantillons de données à compresser Eₙ. Ce conditionnement est optionnel. Le conditionnement des données est une mise en forme des données dans le but de faciliter leur compression.

L'étape de conditionnement E10 produit des échantillons de données à compresser conditionnées ECₙ.

L'étape suivante E11 est une extrapolation réalisée sur les échantillons conditionnés ECₙ. Si le conditionnement n'est pas effectué, l'extrapolation est effectuée sur les échantillons de données à compresser Eₙ. De même, les traitements ultérieurs effectués sur les échantillons conditionnés le sont sur les échantillons de données à compresser.

Différentes fonctions d'extrapolation peuvent être mises en oeuvre. De préférence, la fonction d'extrapolation dépend de la nature du signal à compresser.

A titre d'exemple, la fonction d'extrapolation estime la valeur de l'échantillon courant ECₙ en fonction de la valeur d'au moins un échantillon précédent ECₙ₋₁, ECₙ₋₂, etc. Dans ce cas, la fonction d'extrapolation est par exemple une recopie de l'échantillon précédent. Elle peut également être une fonction, linéaire ou non, de plusieurs échantillons précédents. Alternativement, elle peut encore être une fonction parabolique ou exponentielle.

L'étape suivante E12 est une différenciation effectuée sur chaque couple d'échantillon conditionné et d'échantillon extrapolé correspondant (ECₙ, EEₙ). La différenciation met en oeuvre une fonction déterministe qui associe une unique valeur d'échantillon différencié EDₙ à un couple de valeurs d'échantillon et d'échantillon extrapolé correspondant (ECₙ, EEₙ).

Les valeurs d'échantillon conditionné ECₙ et d'échantillon extrapolé EEₙ correspondant sont a priori proches, si l'extrapolation fonctionne bien. La fonction de différenciation exploite la redondance existant entre les valeurs d'échantillon conditionné ECₙ et d'échantillon extrapolé correspondant EEₙ. Par exemple, la fonction d'extrapolation est la fonction XOR appliquée bit à bit sur les valeurs d'échantillon conditionné ECₙ et d'échantillon extrapolé correspondant EEₙ. En variante, la fonction d'extrapolation est une soustraction non signée.

L'étape suivante E13 est une suppression de redondance dans les échantillons différenciés EDₙ. La suppression de redondance est effectuée comme décrit en référence à la figure 2.

La suppression de redondance considère des blocs de P valeurs successives d'échantillons différenciés et détermine la redondance entre ces P valeurs. Par exemple, le résultat est le nombre NB de bits successifs de poids fort qui ont comme valeur « 0 ». La valeur P est prédéterminée, ou en variante, elle est variable et est codée dans les données de compression.

Les P valeurs successives d'échantillons différenciés sont mémorisées puis tronquées des NB bits successifs redondants.

Enfin, les P valeurs tronquées sont concaténées. Le résultat de l'étape E13 est le signal de données compressées. Ce signal comporte des mots dont chacun correspond à P valeurs traitées et est formé du nombre NB et des P valeurs tronquées.

La **figure 7** représente le fonctionnement du dispositif de décompression de données de la figure 3, sous la forme d'un organigramme comportant des étapes E20 à E23.

L'étape E20 est une dé-concaténation qui effectue des opérations inverses de celles de l'étape de suppression de redondance E13 précédemment décrit. Cette étape comporte une dé-concaténation proprement dite du signal compressé et une réintroduction de redondance dans le signal compressé.

Dans le cas d'une suppression de redondance réalisée comme dans la figure 2, le nombre NB et les P valeurs tronquées d'un mot reçu sont lus. Les NB bits qui avaient été tronqués sont ajoutés à chacune des P valeurs du mot reçu. Par exemple, NB bits de poids fort qui ont comme valeur « 0 » sont ajoutés aux valeurs tronquées. Les valeurs des échantillons différenciés qui représentent l'erreur de la fonction d'extrapolation appliquée par l'étape E11 lors de la compression des données sont ainsi reconstituées. L'étape E20 a pour résultat des valeurs d'échantillons différenciés reconstitués EDRₙ.

L'étape suivante E21 est une dédifférenciation qui applique aux échantillons différenciés reconstitués EDRₙ une fonction inverse de la fonction appliquée par l'étape de différenciation E12 du procédé de compression de données.

L'étape E21 produit un échantillon dédifférencié courant EDDₙ en fonction de l'échantillon différencié reconstitué correspondant EDRₙ résultant de l'étape E20 et d'un échantillon estimé correspondant EESₙ résultant de l'étape E22 décrite dans la suite.

L'étape suivante E22 est une estimation qui utilise une fonction identique à celle utilisée par l'étape d'extrapolation E11 du procédé de compression de données. A partir des échantillons précédemment dédifférenciés EDDₙ fournis par l'étape de dédifférenciation E21, l'étape d'estimation E22 produit des échantillons estimés EESₙ. Par exemple, l'estimation est une recopie de l'échantillon précédent : EESₙ = EDDₙ₋₁, où EDDₙ₋₁ représente l'échantillon précédemment dédifférencié.

Ces échantillons estimés EESₙ sont utilisés par l'étape de dédifférenciation E21 qui applique une fonction inverse de la fonction appliquée par l'étape de différenciation E12 du procédé de compression de données. Selon un mode de réalisation préféré, la fonction de différenciation est la fonction « XOR ». Dans ce cas, la fonction appliquée par le module de dédifférenciation 21 est également la fonction « XOR ».

L'étape E21 est également suivie de l'étape E23 de déconditionnement des échantillons dédifférenciés EDDₙ produits à l'étape E21. Cette étape est optionnelle et est mise en oeuvre lorsque le procédé de compression de données comporte une étape de conditionnement E10.

L'étape de déconditionnement E23 effectue des opérations inverses de celles effectuées par l'étape de conditionnement E10. Par exemple, si le conditionnement comporte le passage d'un codage de type « big endian » à un codage «de type « little endian », alors le déconditionnement réalise la transformation inverse.

Le signal produit à l'étape E23 est le signal de données décompressées produit par le procédé de décompression selon l'invention. Bien entendu, si les opérations de conditionnement/déconditionnement ne sont pas mises en oeuvre, alors c'est le signal produit à l'étape E21 qui est le signal de données décompressées produit par le procédé de décompression selon l'invention.

Selon un autre mode de réalisation, les étapes de conditionnement et de déconditionnement des procédés de compression et décompression de données peuvent être mises en oeuvre respectivement après l'extrapolation et après la dédifférenciation, en ajoutant une étape de conditionnement entre l'estimation et la dédifférenciation dans le procédé de décompression de données.

Les procédés de compression et décompression de données selon l'invention peuvent être mis en oeuvre par un ou des circuit(s) intégré(s) dédié(s) ou par des processeurs programmables, ou encore sous la forme de programmes d'ordinateur mémorisés dans la mémoire d'un ordinateur.

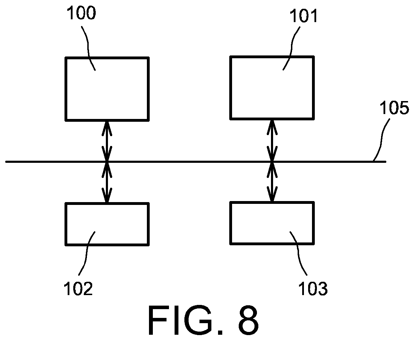

Ainsi, la **figure 8** représente un mode de réalisation particulier de mise en oeuvre de la compression de données selon l'invention.

Le dispositif de compression de données a la structure générale d'un ordinateur. Il comporte notamment un processeur 100 exécutant un programme d'ordinateur mettant en oeuvre le procédé selon l'invention, une mémoire 101, une interface d'entrée 102 et une interface de sortie 103.

Ces différents éléments sont classiquement reliés par un bus 105.

L'interface d'entrée 102 est destinée à recevoir les données à compresser.

Le processeur 100 exécute les traitements précédemment exposés. Ces traitements sont réalisés sous la forme d'instructions de code du programme d'ordinateur qui sont mémorisées par la mémoire 101 avant d'être exécutées par le processeur 100.

La mémoire 101 peut en outre mémoriser les résultats des traitements effectués.

L'interface de sortie 103 fournit les données compressées qui peuvent ensuite être mémorisées et/ou transmises de manière conventionnelle.

Bien entendu, le procédé et le dispositif correspondants de décompression de données sont mis en oeuvre de manière similaire. Un même dispositif peut aussi mettre en oeuvre la compression et la décompression de données.

## Revendications

1. Procédé de compression de données numériques, comportant des étapes de :
Extrapolation (E11) de la valeur de chaque échantillon de données à compresser (ECₙ) en fonction de la valeur d'au moins un échantillon précédent, pour produire un échantillon extrapolé (EEₙ),
Différenciation (E12) entre chaque échantillon extrapolé et l'échantillon de données à compresser correspondant, pour produire un échantillon différencié (EDₙ),
Suppression (E13) de redondance entre échantillons différenciés successifs produits par l'étape de différenciation,
**caractérisé en ce que** l'étape de suppression de redondance entre échantillons différenciés successifs comporte :
- la formation de blocs de P valeurs successives d'échantillons différenciés successifs,
- la détermination, pour chaque bloc, d'un nombre, NB, de bits successifs de poids fort qui ont tous une même valeur "0" ou "1" dans chacun des P échantillons différenciés successifs du bloc considéré, ce nombre NB étant le même pour les P échantillons du bloc considéré,
- la suppression, pour chaque bloc, des NB bits successifs de poids fort qui ont la même valeur dans chacun des P échantillons différenciés successifs du bloc considéré pour produire des échantillons tronqués, et
- l'association, pour chaque bloc, du nombre, NB, de bits successifs de poids fort qui ont une même valeur dans chacun des P échantillons différenciés successifs du bloc considéré aux échantillons tronqués du bloc considéré.

2. Procédé de compression de données numériques selon la revendication 1, **caractérisé en ce que** l'extrapolation (E11) de la valeur d'un échantillon de données à compresser est une recopie de l'échantillon précédent.

3. Procédé de compression de données numériques selon la revendication 1 ou 2, **caractérisé en ce qu'**il comporte une étape de conditionnement de chaque échantillon de données à compresser de manière à mettre en forme les données à compresser.

4. Procédé de compression de données numériques selon l'une quelconque des revendications 1 à 3, **caractérisé en ce qu'**il comporte une étape de concaténation (E13) des échantillons tronqués.

5. Procédé de décompression de données numériques compressées par le procédé selon l'une quelconque des revendications 1 à 4, **caractérisé en ce qu'**il comporte des étapes de :
Réintroduction (E20) de redondance dans le signal compressé, pour produire des échantillons reconstitués (EDRₙ),
Dédifférenciation (E21) entre chaque échantillon reconstitué (EDRₙ) et un échantillon estimé correspondant (EESₙ), pour produite un échantillon dédifférencié (EDDₙ),
Estimation (E22) de la valeur de chaque échantillon estimé suivant à partir de la valeur d'au moins un échantillon dédifférencié précédemment produit (EDDₙ₋₁).

6. Procédé de décompression de données numériques selon la revendication 5, **caractérisé en ce que** l'estimation (E22) de la valeur d'un échantillon estimé suivant est effectuée par la même fonction que pour l'extrapolation lors de la compression de données.

7. Dispositif de compression de données numériques, comportant :
Des moyens (11) d'extrapolation de la valeur de chaque échantillon de données à compresser en fonction de la valeur d'au moins un échantillon précédent, pour produire un échantillon extrapolé,
Des moyens (12) de différenciation entre chaque échantillon extrapolé et l'échantillon de données à compresser correspondant, pour produire un échantillon différencié,
Des moyens (13) de suppression de redondance entre échantillons différenciés successifs produits par l'étape de différenciation,
**caractérisé en ce que** les moyens de suppression sont adaptés à :
- former des blocs de P valeurs successives d'échantillons différenciés successifs,
- déterminer, pour chaque bloc, un nombre, NB, de bits successifs de poids fort qui tous ont une même valeur "0" ou "1" dans chacun des P échantillons différenciés successifs du bloc considéré, ce nombre NB étant le même pour les P échantillons du bloc considéré,
- supprimer, pour chaque bloc, les NB bits successifs de poids fort qui ont la même valeur dans chacun des P échantillons différenciés successifs du bloc considéré pour produire des échantillons tronqués, et
- associer, pour chaque bloc, le nombre NB de bits successifs de poids fort qui ont une même valeur dans chacun des P échantillons différenciés successifs du bloc considéré aux échantillons tronqués du bloc considéré.

8. Dispositif de décompression de données compressées par le dispositif selon la revendication 7, **caractérisé en ce qu'**il comporte :
Des moyens (20) de réintroduction de redondance dans le signal compressé, pour produire des échantillons reconstitués,
Des moyens (21) de dédifférenciation entre chaque échantillon reconstitué et un échantillon estimé correspondant, pour produite un échantillon dédifférencié,
Des moyens (22) d'estimation de la valeur de chaque échantillon estimé suivant à partir de la valeur d'au moins un échantillon dédifférencié précédemment produit.

9. Programme d'ordinateur comportant des instructions pour l'exécution des étapes du procédé selon l'une quelconque des revendications 1 à 6 lorsque ledit programme est exécuté par un ordinateur.

10. Support d'enregistrement lisible par un ordinateur sur lequel est enregistré un programme d'ordinateur comprenant des instructions pour l'exécution des étapes du procédé selon l'une quelconque des revendications 1 à 6.

## Patentansprüche

1. Verfahren zum Komprimieren digitaler Daten, das die folgenden Schritte umfasst:
Extrapolieren (E11) des Werts jeder zu komprimierenden Datenstichprobe (ECₙ) als Funktion des Werts von mindestens einer vorhergehenden Stichprobe, um eine extrapolierte Stichprobe (EEₙ) zu erzeugen,
Differenzieren (E12) zwischen jeder extrapolierten Stichprobe und der entsprechenden zu komprimierenden Datenstichprobe, um eine differenzierte Stichprobe zu erzeugen,
Löschen (E13) der Redundanz zwischen aufeinanderfolgenden differenzierten Stichproben, die durch den Schritt des Differenzierens erzeugt wurden,
**dadurch gekennzeichnet, dass** der Schritt des Löschens der Redundanz zwischen aufeinanderfolgenden differenzierten Stichproben Folgendes umfasst:
- Bilden von Blöcken aus P aufeinanderfolgenden Werten von aufeinanderfolgenden differenzierten Stichproben,
- Bestimmen, für jeden Block, einer Anzahl, NB, aufeinanderfolgender höchstwertiger Bits, die alle den gleichen Wert "0" oder "1" in jeder der P aufeinanderfolgenden differenzierten Stichproben des betrachteten Blocks haben, wobei die Anzahl NB die gleiche ist für die P Stichproben des betrachteten Blocks,
- Löschen, für jeden Block, der NB aufeinanderfolgenden höchstwertigen Bits, die den gleichen Wert in jeder der P aufeinanderfolgenden differenzierten Stichproben des betrachteten Blocks haben, um gekürzte Stichproben zu erzeugen, und
- Zuordnen, für jeden Block, der Anzahl, NB, aufeinanderfolgender höchstwertiger Bits, die den gleichen Wert in jeder der P aufeinanderfolgenden differenzierten Stichproben des betrachteten Blocks haben, zu den gekürzten Stichproben des betrachteten Blocks.

2. Verfahren zum Komprimieren digitaler Daten nach Anspruch 1, **dadurch gekennzeichnet, dass** das Extrapolieren (E11) des Werts einer zu komprimierenden Datenstichprobe eine Kopie der vorhergehenden Stichprobe ist.

3. Verfahren zum Komprimieren digitaler Daten nach Anspruch 1 oder 2, **dadurch gekennzeichnet, dass** es einen Schritt des Konditionierens jeder zu komprimierenden Datenstichprobe umfasst, um die zu komprimierenden Daten zu formatieren.

4. Verfahren zum Komprimieren digitaler Daten nach einem der vorhergehenden Ansprüche 1 bis 3, **dadurch gekennzeichnet, dass** es einen Schritt des Verknüpfens (E13) aufeinanderfolgender differenzierter Stichproben umfasst.

5. Verfahren zum Dekomprimieren digitaler Daten, die durch das Verfahren nach einem der Ansprüche 1 bis 4 komprimiert wurden, **dadurch gekennzeichnet, dass** es die folgenden Schritte umfasst:
Wiedereinführen (E20) von Redundanz in das komprimierte Signal, um rekonstituierte Stichproben (EDRₙ) zu erzeugen,
Entdifferenzieren (E21) zwischen jeder rekonstituierten Stichprobe (EDRₙ) und einer entsprechenden geschätzten Stichprobe (EESₙ), um eine entdifferenzierte Stichprobe (EDDₙ) zu erzeugen,
Schätzen (E22) des Werts jeder folgenden geschätzten Stichprobe anhand des Werts von mindestens einer vorher erzeugten entdifferenzierten Stichprobe (EDDₙ₋₁).

6. Verfahren zum Dekomprimieren digitaler Daten nach Anspruch 5, **dadurch gekennzeichnet, dass** das Schätzen (E22) des Werts einer folgenden geschätzten Stichprobe durch dieselbe Funktion wie beim Extrapolieren während der Datenkompression durchgeführt wird.

7. Vorrichtung zum Komprimieren digitaler Daten, die Folgendes umfasst:
ein Mittel (11) zum Extrapolieren des Werts jeder zu komprimierenden Datenstichprobe als Funktion des Werts von mindestens einer vorhergehenden Stichprobe, um eine extrapolierte Stichprobe zu erzeugen,
ein Mittel (12) zum Differenzieren zwischen jeder extrapolierten Stichprobe und der entsprechenden zu komprimierenden Datenstichprobe, um eine differenzierte Stichprobe zu erzeugen,
ein Mittel (13) zum Löschen der Redundanz zwischen aufeinanderfolgenden differenzierten Stichproben, die durch den Schritt des Differenzierens erzeugt wurden,
**dadurch gekennzeichnet, dass** das Löschmittel für Folgendes ausgebildet ist:
- Bilden von Blöcken aus P aufeinanderfolgenden Werten von aufeinanderfolgenden differenzierten Stichproben,
- Bestimmen, für jeden Block, einer Anzahl, NB, aufeinanderfolgender höchstwertiger Bits, die alle den gleichen Wert "0" oder "1" in jeder der P aufeinanderfolgenden differenzierten Stichproben des betrachteten Blocks haben, wobei die Anzahl NB die gleiche ist für die P Stichproben des betrachteten Blocks,
- Löschen, für jeden Block, der NB aufeinanderfolgenden höchstwertigen Bits, die den gleichen Wert in jeder der P aufeinanderfolgenden differenzierten Stichproben des betrachteten Blocks haben, um gekürzte Stichproben zu erzeugen, und
- Zuordnen, für jeden Block, der Anzahl, NB, aufeinanderfolgender höchstwertiger Bits, die den gleichen Wert in jeder der P aufeinanderfolgenden differenzierten Stichproben des betrachteten Blocks haben, zu den gekürzten Stichproben des betrachteten Blocks.

8. Vorrichtung zum Komprimieren digitaler Daten nach Anspruch 7, **dadurch gekennzeichnet, dass** sie Folgendes umfasst:
ein Mittel (20) zum Wiedereinführen von Redundanz in das komprimierte Signal, um rekonstituierte Stichproben zu erzeugen,
ein Mittel (21) zum Entdifferenzieren zwischen jeder rekonstituierten Stichprobe und einer entsprechenden geschätzten Stichprobe, um eine entdifferenzierte Stichprobe zu erzeugen,
ein Mittel (22) zum Schätzen des Werts jeder folgenden geschätzten Stichprobe anhand des Werts von mindestens einer vorher erzeugten entdifferenzierten Stichprobe.

9. Computerprogramm, dass Anweisungen zum Ausführen der Schritte des Verfahrens nach einem der Ansprüche 1 bis 6 umfasst, wenn das Programm von einem Computer ausgeführt wird.

10. Computerlesbares Speichermedium, auf dem ein Computerprogramm gespeichert ist, das die Anweisungen zum Ausführen der Schritte des Verfahrens nach einem der Ansprüche 1 bis 6 umfasst.

## Claims

1. Method for compressing digital data comprising steps of:
Extrapolating (E11) the value of each sample of data to be compressed (ECₙ) as a function of the value of at least one preceding sample, in order to produce an extrapolated sample (EEₙ),
Differentiating (E12) between each extrapolated sample and the corresponding sample of data to be compressed, in order to produce a differentiated sample (EDₙ),
Deleting (E13) redundancy between successive differentiated samples produced by the differentiating step,
**characterised in that** the step of deleting redundancy between successive differentiated samples comprises:
- forming blocks of P successive values of successive differentiated samples,
- determining, for each block, of a number, NB, of successive most significant bits which all have a same value "0" or "1" in each of the P successive differentiated samples of the block under consideration, this number NB being the same for the P samples of the block under consideration,
- deleting, for each block, the NB successive most significant bits which have the same value in each of the P successive differentiated samples of the block under consideration to produce truncated samples, and
- associating, for each block, the number, NB, of successive most significant bits which have the same value in each of the P successive differentiated samples of the block under consideration with the truncated samples of the block under consideration.

2. Method for compressing digital data according to claim 1, **characterised in that** the extrapolation (E11) of the value of a sample of data to be compressed is a copy of the preceding sample.

3. Method for compressing digital data according to claim 1 or 2, **characterised in that** it comprises a step of conditioning each sample of data to be compressed in such a way as to format the data to be compressed.

4. Method for compressing digital data according to any of claims 1 to 3, **characterised in that** it comprises a step of concatenation (E13) of the truncated samples.

5. Method for decompressing digital data compressed by the method according to any of claims 1 to 4, **characterised in that** it comprises steps of:
Re-introducing (E20) redundancy into the compressed signal, in order to produce reconstituted samples (EDRₙ),
De-differentiating (E21) between each reconstituted sample (EDRₙ) and a corresponding estimated sample (EESₙ), in order to produce a de-differentiated sample (EDDₙ),
Estimating (E22) the value of each following estimated sample from the value of at least one previously produced de-differentiated sample (EDDₙ₋₁).

6. Method for decompressing digital data according to claim 5, **characterised in that** the estimation (E22) of the value of a following estimated sample is carried out by the same function as for the extrapolation during data compression.

7. Digital data compression device comprising:
Means (11) for extrapolating the value of each sample of data to be compressed as a function of the value of at least one preceding sample, in orderto produce an extrapolated sample,
Means (12) for differentiating between each extrapolated sample and the corresponding sample of data to be compressed, in order to produce a differentiated sample,
Means (13) for deleting redundancy between successive differentiated samples produced by the differentiating step,
**characterised in that** the means for deleting are adapted to:
- forming blocks of P successive values of successive differentiated samples,
- determining, for each block, of a number, NB, of successive most significant bits which all have a same value "0" or "1" in each of the P successive differentiated samples of the block under consideration, this number NB being the same for the P samples of the block under consideration,
- deleting, for each block, the NB successive most significant bits which have the same value in each of the P successive differentiated samples of the block under consideration to produce truncated samples, and
- associating, for each block, the number, NB, of successive most significant bits which have the same value in each of the P successive differentiated samples of the block under consideration with the truncated samples of the block under consideration.

8. Device for decompressing data compressed by the device according to claim 7, **characterised in that** it comprises:
Means (20) for re-introducing redundancy into the compressed signal, in order to produce reconstituted samples,
Means (21) for de-differentiating between each reconstituted sample and a corresponding estimated sample, in order to produce a de-differentiated sample,
Means (22) for estimating the value of each following estimated sample from the value of at least one previously produced de-differentiated sample.

9. Computer program comprising instructions for the execution of the steps of the method according to any of claims 1 to 6 when said program is executed by a computer.

10. Recording support which can be read by a computer on which is recorded a computer program including instructions for the execution of the steps of the method according to any of claims 1 to 6.
